# EUROPEAN PATENT SPECIFICATION

(11) **EP 0 924 774 B1**
(45) Date of publication and mention of the grant of the patent: **29.08.2007**
(21) Application number: 98310178.3
(22) Date of filing: 11.12.1998
(51) Int. Cl.: H01L 31/02, H01L 27/146

(54) **Redundant multitier contacts for a solid state x-ray detector**
Kontakten in mehreren Lagen für einen Röntgenstrahlendetektor
Contacts à plusieurs niveaux redondants pour un détecteur de rayons x

(30) Priority: 19.12.1997 US 994396
(43) Date of publication of application: 23.06.1999
(73) Proprietor: GENERAL ELECTRIC COMPANY, Schenectady, NY 12345 (US)
(72) Inventor: Vafi, Habib, Waukesha, Wisconsin 53186 (US); Petrick, Scott William, Sussex, Wisconsin 53089 (US); Allen, Philip Marshall, Oconomowoc, Wisconsin 53066 (US); Saunders, Rowland Frederick, Hartland, Wisconsin 53029 (US)
(74) Representative: Goode, Ian Roy

(56) References cited:
- US-A- 5 475 246
- PATENT ABSTRACTS OF JAPAN vol. 097, no. 010, 31 October 1997 (1997-10-31) -& JP 09 152486 A (CANON INC), 10 June 1997 (1997-06-10) -& US 5 777 335 A (CANON) 7 July 1998 (1998-07-07)

## Description

The present invention relates to integrated circuits and more particularly, to a connection means for extracting a signal and digital value from a solid state X-ray detector.

Connection to a solid state X-ray detector, which consists of thousands of contacts per detector, is accomplished in much the same manner as connections to flat panel displays are made. That is, by using fine pitch flexible circuits between the glass substrate and the associated electronics. A row of fine pitch metal contacts is fabricated on the glass substrate and the flex circuit is fabricated with a matching contact pattern. The flex is "bonded" to the glass substrate by applying heat and pressure to a film, such as an anisotropic conductive film, that contains particles which conduct in the Z-axis only (i.e., between the glass substrate and the flex) after the bonding process.

One big difference between displays and detectors is the volume produced. Flat panel display production is driven by the portable computer market and is therefore much higher volume than solid state detectors. This impacts the cost of the panel as well as the associated electronics. Hence, it is more economically attractive to eliminate scrap in the case of the detectors, as the cost of the components are higher due to the lower volume.

Unfortunately, attempts to salvage defect free components are difficult, since the process of cleaning the anisotropic conductive film material from the glass substrate is often destructive to the materials deposited on the glass as well, resulting in the loss of a good substrate. Conversely, in the case of a defective substrate, it is desirable to salvage the associated electronics, without damage. Again, the flex is a very fragile substrate and the contact pattern bonded to the glass is usually damaged beyond salvage when removing the bonded flex from the glass. When this flex is an integral part of the associated electronics, this means that the electronics must be scrapped as well.

It is seen then that, in those instances where the bonding process produces a poor connection, or if either the detector itself or part of the associated electronics proves to be defective, it would be desirable to be able to salvage the remaining parts that are defect free, in order to contain costs.

In accordance with the present invention, defect free portions of solid state X-ray detector connections can be salvaged in instances where the bonding process produces a poor connection in an isolated area, or the detector and/or associated electronics can be salvaged if either the detector or part of the associated electronics are defective.

In accordance with the present invention, a connection method for connecting scan and data integrated circuits, or row and column drive components, such as a detector and associated electronics, comprises the steps of providing a glass substrate; depositing a plurality of sets of contacts on the glass substrate; providing associated electronics for connection to the glass substrate; depositing a plurality of sets of contacts on the associated electronics; bonding a flexible connection means to one of the plurality of sets of contacts on the glass substrate; and using the flexible connection means to form a connection to one of the plurality of sets of contacts on the associated electronics.

Accordingly, it is an object of the present invention to provide a connection method for connecting components multiple times as defined in claim 1. This has the advantage of minimizing scrap of good components after a permanent connection is made between the components and either some of the components or the connection itself is found to be defective. The present invention has the further advantage of eliminating the effort and expense of attempting to clean and salvage components which are permanently connected.

An embodiment of the invention will now be described, by way of example, with reference to the accompanying drawings, in which:-
Fig. 1 illustrates multiple sets of contacts on a first component which is to be connected to a second component, in accordance with the present invention; and
Figs. 2A through 2E illustrate various connection configurations from one of the multiple sets of contacts on one component to one of multiple sets of contacts on the second component, in accordance with the present invention, where Fig. 2A is a top view and Figs. 2B-2E are side views.

In accordance with the present invention, the goal of reducing scrap and rework costs, particularly with connections between solid state X-ray detector components, can be achieved by fabricating components with multiple sets of contacts.

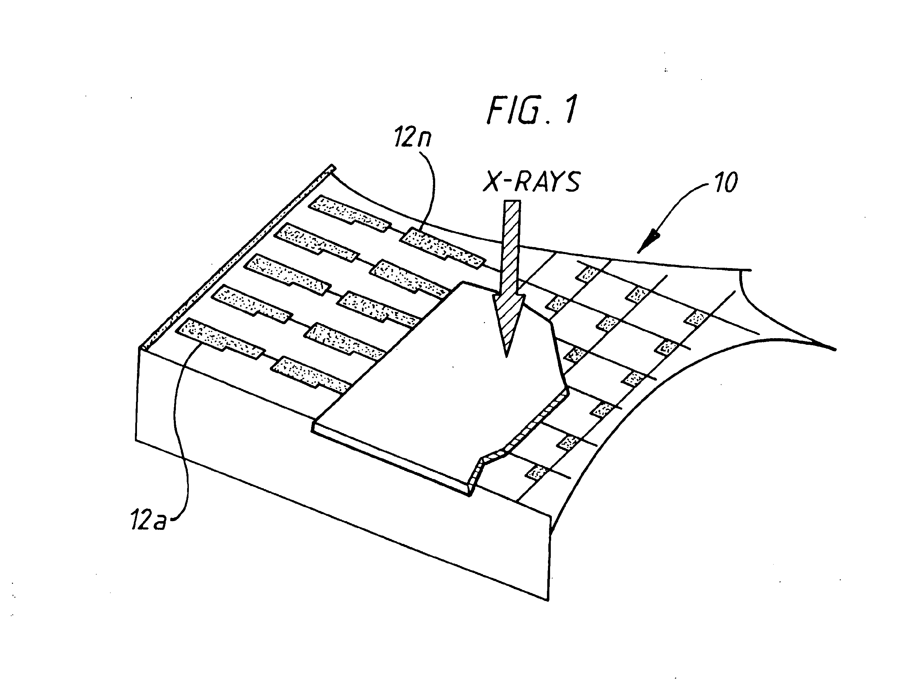

Referring now to the drawings, the concept of the present invention is illustrated. In Fig. 1, a first component, such as a glass substrate 10 typically forming the basis of a solid state X-ray detector, is deposited with multiple sets of contacts 12a, 12n, rather than a single set of contacts as known in the prior art JP 09 152 486. Hence, when a flexible circuit (such as would be initially attached to contacts 12a) is removed from the glass substrate 10, another row of contacts, 12n, would be available to bond a fresh flex circuit, without having to replace the glass substrate 10.

As can be seen in Fig. 1, the size of the glass substrate 10 would increase by the amount of each additional metal contact pattern 12n on each side that the contact pattern exists. Each additional contact pattern 12n allows for an additional bonding occurrence to the glass substrate 10. Hence, the glass substrate 10 could be bonded once for each set of contact patterns 12 that are deposited on the glass substrate 10. Each bond would be to a fresh set of contacts on the panel 10. Likewise, the flex would also have to increase in length in order to contact the "inner" set of contacts 12n. Consequently, it will be obvious to those skilled in the art that the number of additional contact rows 12n is limited only by the desired size of the glass substrate 10 and length of the flex.

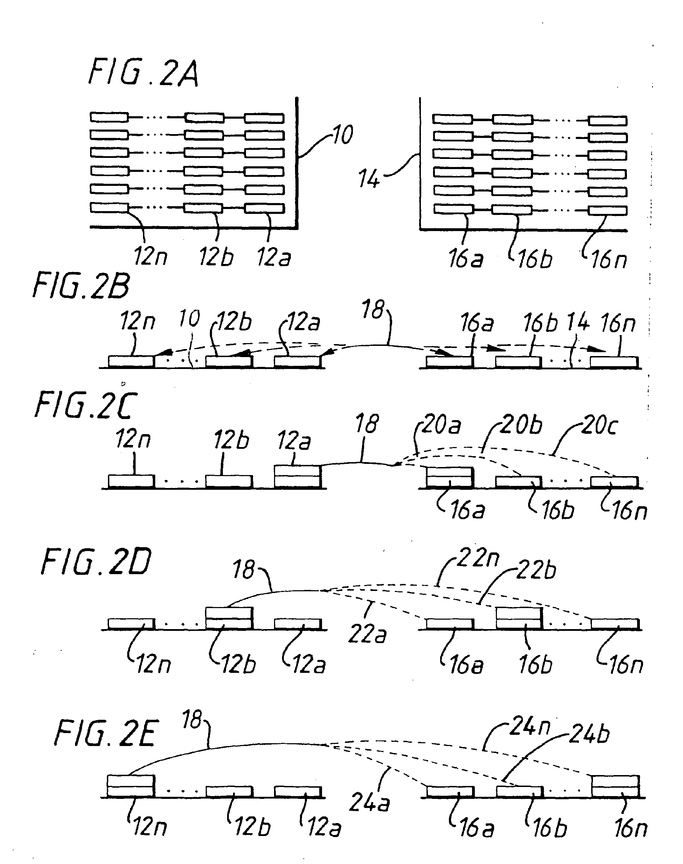

Referring now to Figs. 2A through 2E, the first component 10 is meant to be connected to a second or subsequent component, such as associated electronics 14. Again, in accordance with the present invention, more than one set of contacts 16 can be fabricated on the second component 14. The number of contacts 12 can vary from the number of contacts 16, as indicated by the contact rows 12n and 16n, where n can represent any multiple of one

To most clearly illustrate the concept of the present invention, only contact patterns are illustrated, and the interconnecting traces have been eliminated. The first bond, by way of example, would be via a flex 18 from any one of the multiple sets of contacts 12 (12a, 12b, 12n) on the first component to any one of the multiple sets of contacts 16 (16a, 16b, 16n) on the second component, as illustrated by lines 20a, 20b, 20c, 22a, 22b, 22c, 24a, 24b, 24c, representing the flex connection.

If the panel 10, the multi-chip module 14, or the bond between the components 10 and 14 is defective, the flex 18 could simply be peeled from the panel 10. A subsequent contact set can be made available for bonding the first and second components 10 and 14 (if the original bond were defective), or the undamaged component to a new component altogether (if one of the original components were defective). Rather than replace both components and the flex when a bond proves defective, the present invention allows for replacement of only the flex, or only the defective component.

The flex18 length would necessarily increase by the length of each contact pattern which is added, and the design would be required to accommodate this extra length when the first bond produces a defect free assembly. Additional contact patterns are also preferably protected from contamination and humidity when they are not used, in order to avoid artifacts due to potential shorting or introduction of leakage paths. When the flex 18 is attached to the electronics 14 in a similar fashion, the same idea can be applied to the opposite end of the flex, making it possible to replace the electronics independent of the connection at the glass substrate 10, as illustrated in Figs. 2A-2E.

## Claims

1. A connection method for connecting components, the connection method comprising the steps of:
providing a fine pitch component (10) on a substrate;
depositing a plurality of sets of contacts (12) on the substrate (10) ;
providing associated electronics (14) to be connected to the fine pitch component (10);
bonding a flexible connection means (18) to one of the plurality of sets of contacts (12) of the fine pitch component (10); and
using the flexible connection means (18) to form a connection to the associated electronics (14).

2. A connection method as claimed in claim 1 wherein alternative ones of the plurality of sets of contacts (12) of the fine pitch component (10) can be used when a poor connection is made.

3. A connection method as claimed in claim 1 wherein alternative ones of the plurality of sets of contacts (12) of the fine pitch component (10) can be used when the associated electronics (14) are defective but the fine pitch component (10) can be salvaged.

4. A connection method as claimed in claim 1 wherein a quantity value of the plurality of sets of contacts (12) of the fine pitch component (10) is limited by size of the fine pitch component (10) and length of the flexible connection means (18).

5. A connection method as claimed in claim 1 further comprising the step of depositing a plurality of sets of contacts (16) on the associated electronics (14).

6. A connection method as claimed in claim 5 wherein alternative ones of the plurality of sets of contacts (16) on the associated electronics (14) can be used when a poor connection is made.

7. A connection method as claimed in claim 5 wherein alternative ones of the plurality of sets of contacts (16) on the associated electronics (14) can be used when the fine pitch component (10) is defective but the associated electronics (14) can be salvaged.

8. A connection method as claimed in claim 5 wherein alternative ones of the plurality of sets of contacts (12) of the fine pitch component (10) and alternative ones of the plurality of sets of contacts (16) on the associated electronics (14) can be used when a poor connection is made.

9. A connection method as claimed in claim 5 wherein a quantity value of the plurality of sets of contacts (16) on the associated electronics (14) is limited by size of the associated electronics (14) component and length of the flexible connection means (18).

## Patentansprüche

1. Verbindungsverfahren zum Verbinden von Komponenten, wobei das Verbindungsverfahren folgende Schritte umfasst:
Bereitstellen einer Feinraster-Komponente (10) auf einem Substrat; Auftragen mehrerer Sätze von Kontakten (12) auf das Substrat (10);
Bereitstellen der zugehörigen Elektronik (14), die mit der Feinraster-Komponente (10) zu verbinden ist;
Verbinden einer biegsamen Verbindungseinrichtung (18) mit einem der mehreren Sätze von Kontakten (12) der Feinraster-Komponente (10); und
Verwenden der biegsamen Verbindungseinrichtung (18), um eine Verbindung zu der zugehörigen Elektronik (14) zu bilden.

2. Verbindungsverfahren nach Anspruch 1, **dadurch gekennzeichnet, dass** alternative Kontaktsätze der Mehrzahl Kontaktsätze (12) der Feinraster-Komponente (10) verwendet werden können, wenn eine schlechte Verbindung hergestellt wurde.

3. Verbindungsverfahren nach Anspruch 1, **dadurch gekennzeichnet, dass** alternative Kontaktsätze der Mehrzahl Kontaktsätze (12) der Feinraster-Komponente (10) verwendet werden können, wenn die zugehörige Elektronik (14) defekt ist, die Feinraster-Komponente (10) aber verwertet werden kann.

4. Verbindungsverfahren nach Anspruch 1, **dadurch gekennzeichnet, dass** der Größenwert der Mehrzahl der Kontaktsätze (12) der Feinraster-Komponente (10) von der Größe der Feinraster-Komponente (10) und der Länge der flexiblen Verbindungseinrichtung (18) begrenzt wird.

5. Verbindungsverfahren nach Anspruch 1, das ferner das Auftragen einer Mehrzahl von Kontaktsätzen (16) auf die zugehörige Elektronik (14) umfasst.

6. Verbindungsverfahren nach Anspruch 5, **dadurch gekennzeichnet, dass** alternative Kontaktsätze der Mehrzahl von Kontaktsätzen (16) auf der zugehörigen Elektronik (14) verwendet werden können, wenn eine schlechte Verbindung hergestellt wurde.

7. Verbindungsverfahren nach Anspruch 5, **dadurch gekennzeichnet, dass** alternative Kontaktsätze der Mehrzahl Kontaktsätze (16) auf der zugehörigen Elektronik (14) verwendet werden können, wenn die Feinraster-Komponente (10) defekt ist, die zugehörige Elektronik (14) aber verwertet werden kann.

8. Verbindungsverfahren nach Anspruch 5, **dadurch gekennzeichnet, dass** alternative Kontaktsätze der Mehrzahl von Kontaktsätzen (12) der Feinraster-Komponente (10) und alternative Kontaktsätze der Mehrzahl Kontaktsätze (16) auf der zugehörigen Elektronik (14) verwendet werden können, wenn eine schlechte Verbindung hergestellt wurde.

9. Verbindungsverfahren nach Anspruch 5, **dadurch gekennzeichnet, dass** der Größenwert der Mehrzahl von Kontaktsätzen (16) auf der zugehörigen Elektronik (14) von der Größe der zugehörigen Elektronikkomponente (14) und der Länge der flexiblen Verbindungseinrichtung (18) begrenzt wird.

## Revendications

1. Procédé de connexion pour connecter des composants, le procédé de connexion comprenant les étapes consistant à :
fournir un composant à pas fin (10) sur un substrat ;
déposer une pluralité d'ensembles de contacts (12) sur le substrat (10) ;
fournir de l'électronique associée (14) à connecter au composant à pas fin (10) ;
coller un moyen de connexion flexible (18) sur l'un des ensembles de contacts (12) du composant à pas fin (10) ; et
utiliser le moyen de connexion flexible (18) pour former une connexion avec l'électronique associée (14).

2. Procédé de connexion selon la revendication 1, dans lequel d'autres ensembles de la pluralité d'ensembles de contacts (12) du composant à pas fin (10) peuvent être utilisés lorsqu'une connexion de mauvaise qualité est réalisée.

3. Procédé de connexion selon la revendication 1, dans lequel d'autres ensembles de la pluralité d'ensembles de contacts (12) du composant à pas fin (10) peuvent être utilisés lorsque l'électronique associée (14) est défectueuse mais que le composant à pas fin (10) peut être récupéré.

4. Procédé de connexion selon la revendication 1, dans lequel une valeur de quantité de la pluralité d'ensembles de contacts (12) du composant à pas fin (10) est limitée par la taille du composant à pas fin (10) et par la longueur du moyen de connexion flexible (18).

5. Procédé de connexion selon la revendication 1, comprenant en outre l'étape consistant à déposer une pluralité d'ensembles de contacts (16) sur l'électronique associée (14).

6. Procédé de connexion selon la revendication 5, dans lequel d'autres ensembles de la pluralité d'ensembles de contacts (16) sur l'électronique associée (14) peuvent être utilisés lorsqu'une connexion de mauvaise qualité est réalisée.

7. Procédé de connexion selon la revendication 5, dans lequel d'autres ensembles de la pluralité d'ensembles de contacts (16) sur l'électronique associée (14) peuvent être utilisés lorsque le composant à pas fin (10) est défectueux mais que l'électronique associée (14) peut être récupérée.

8. Procédé de connexion selon la revendication 5, dans lequel d'autres ensembles de la pluralité d'ensembles de contacts (12) du composant à pas fin (10) et d'autres ensembles de la pluralité d'ensembles de contacts (16) sur l'électronique associée (14) peuvent être utilisés lorsqu'une connexion de mauvaise qualité est réalisée.

9. Procédé de connexion selon la revendication 5, dans lequel une valeur de quantité de la pluralité d'ensembles de contacts (16) sur l'électronique associée (14) est limitée par la taille de l'électronique associée (14) et par la longueur du moyen de connexion flexible (18).
